(19) 

Europäisches
Patentamt
European
Patent Office
Office européen
des brevets

(11) **EP 3 349 133 A1**

(12) **EUROPEAN PATENT APPLICATION**
published in accordance with Art. 153(4) EPC

(43) Date of publication:
**18.07.2018 Bulletin 2018/29**

(21) Application number: **16843722.6**

(22) Date of filing: **12.09.2016**

(51) Int Cl.:
*G06F 17/40* (2006.01)

(86) International application number:
**PCT/ES2016/070638**

(87) International publication number:
**WO 2017/042417 (16.03.2017 Gazette 2017/11)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **11.09.2015 ES 201531300**

(71) Applicant: **Metro de Madrid, S.A.**
**28007 Madrid (ES)**

(72) Inventors:
• **SANCHO DE MINGO, Carlos**
**28007 Madrid (ES)**
• **PASCUAL GONZALEZ, Pedro, Pablo**
**28007 Madrid (ES)**
• **BENITO DEL MONTE, Dámaso**
**28007 Madrid (ES)**
• **CEZÓN DOMÍNGUEZ, Angel, Rufino**
**28007 Madrid (ES)**
• **DE LA PEÑA LLERANDI, Jaime**
**28007 Madrid (ES)**

(74) Representative: **Herrero & Asociados, S.L.**
**Cedaceros, 1**
**28014 Madrid (ES)**

(54) **METHOD AND SYSTEM FOR ACQUIRING DIGITAL DATA WITH POWER REDUCTION**

(57) The present invention relates to a method and a system for acquiring digital data with power reduction in synchronous sequential circuits controlled by a synchronization signal with a period T. The method comprises: receiving an item of input data during a first synchronization cycle; transmitting the received item to a memory module; requesting from the memory module, in a second synchronization cycle, an input-data reading, by means of a microprocessor; providing the stored item of data to the microprocessor; receiving a second item of input data by a capturing module during the second synchronization cycle; transmitting the second item to the memory module; and replacing the first stored item of data with the second item of data in the memory module.

**EP 3 349 133 A1**

**Description**

## TECHNICAL FIELD OF THE INVENTION

The present invention is applicable in the field of digital electronics, and more specifically, in digital data acquisition during control processes with a reduction of dissipated power, such as control boards for air conditioning units.

## BACKGROUND OF THE INVENTION

Nowadays, the control of processes requires the reading of analog and digital signals. Input readings are processed by a central control unit which, according to the logic used, activates the corresponding outputs for controlling the process.
To take readings of digital voltage signals, there are solutions in the state of the art with both optical isolation and without optical isolation.
For example, in the case of continuous measurements without isolation wherein the measurement is done in a continuous manner, a compromise must be reached between the current with which the measurement is taken and the dissipation of the circuit, since the power dissipated by the circuit is the product of the voltage read by the read current. On this point it is important to highlight that in noisy systems, if the measuring current is low, false measurements may occur due to induced voltages. Likewise, when the voltages read are fixed by contactors or relays, errors in the reading may occur due to dirt on the contacts.

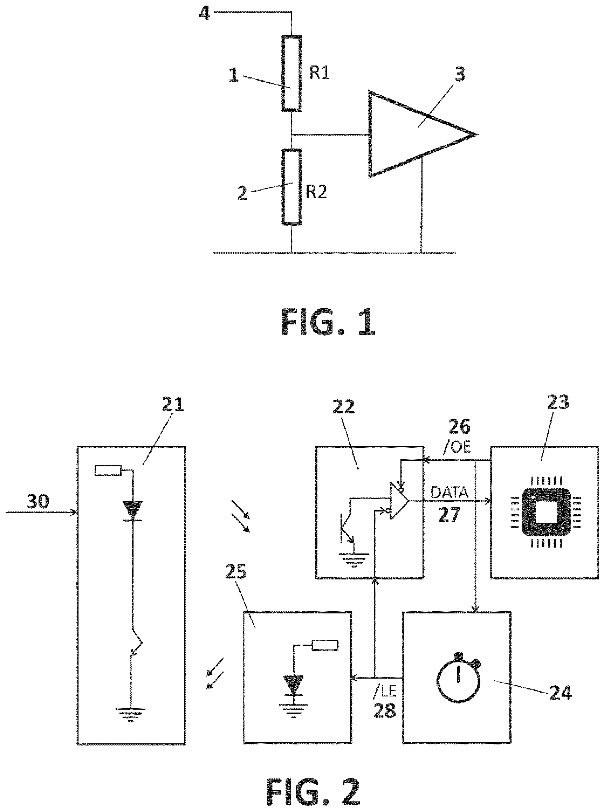

Figure 1, without including the R/C filtering networks or the rest of the necessary components, shows the most simple circuit for a case of continuous measurements without isolation, wherein the reading is taken by means of a resistive divider. The value of the current of which the measurement is taken is fixed by the values of the resistors (1, 2) and the value of the voltage to be measured (4), linearly depending on the current of the voltage to be measured. With this system, the power that is dissipated quadratically depends on the voltage to be measured.
In a very similar way, a circuit in which one of the previous resistors is substituted by a current source for taking readings can be used. The value of the current with which the measurement is taken is fixed by the current source and is independent from the value of the voltage to be measured. With this system, the power dissipated linearly depends on the voltage to be measured.
Another solution in the state of the art also responds to a circuit for continuous measurement of the voltage signal, but in this case with isolation. In noisy systems it is normal to electrically isolate the control signals and the control logic. In the same way as in circuits without isolation, a compromise must be reached between the measuring current and the power dissipated, involving the same problems. The circuits used are basically the same as previously explained, without isolation, but with the particularity in that these circuits introduce an optocoupler for separating the voltage references. The reading is then taken by means of a resistor or current source and the optocoupler can be placed before or after the capturing module (3), although if placed after the capturing module, auxiliary voltage isolated from the control voltage will be required.
Lastly, in the case of non-continuous measuring circuits for the voltage signal, where in order to avoid problems of measuring with low current and too much power from dissipating, circuits are used that maintain the input active only for the time needed to take the measurement, such that power is only dissipated while the measurement is being taken and the average power is very low. The big drawback of these types of circuits is that the control system has to wait for the measurement during the time this process lasts. If further isolation is required, optocouplers can be placed before or after the capturing module to isolate both the measurement as well as the activation signal. But in these cases, the times needed to take the measurement are greater than the times without isolation, since the delays introduced by the optocouplers must be taken into consideration, and therefore to minimize this problem, high-speed optocouplers are frequently used, the photo-transistors of which cannot withstand high voltages, approximately 60V.
In light of the foregoing, the state of the art is in need of a solution for reading digital voltage signals in the control of processes that allows low measuring currents to be avoided and, in turn, isolates the circuits without long wait times and without large amounts of dissipated power that damage equipment due to an increase in heat, all of which is preferably done without significant modifications to the systems or special requirements in the signal input.

## DESCRIPTION OF THE INVENTION

The present invention solves the aforementioned problems in reading digital voltage signals by means of a system for acquiring digital data in synchronized sequential circuits controlled by a synchronization signal with a period T (which can be fixed or variable). The system comprises the following elements:

- a capturing module that reads input data with a period T, wherein the period can be fixed or variable;

- a memory module that stores the input data received by the controller module;
- a controller module that requests input data readings from the memory module and receives the input data stored by the memory module corresponding to the period before the request of the reading;

Additionally, the capturing module can comprise an activation circuit that consists of an optocoupled system in the reverse direction that disables the capturing module when it is not necessary to acquire input data. This way the power consumption is advantageously reduced to the moments in which it is necessary to acquire input data.

Optionally, the capturing module can have a galvanically isolated circuit. Advantageously, this way the control systems are protected from importunate signals.

In one of the embodiments of the invention, it is envisaged that the memory module comprises a latch or bistable multivibrator.

The synchronization signal that controls the circuit can be generated in a synchronization module that is also envisaged in one of the particular embodiments, which in addition generates an activation signal for the capturing module and a memory signal for the memory module. This way, the acquisition and memory of the data are perfectly synchronized with the readings of the microprocessor.

The synchronization module, according to one of the embodiments of the invention, comprises a clock that generates an activation signal with a fixed period.

The synchronization module, according to one of the embodiments of the invention, comprises a clock that generates an activation signal with a variable period.

According to one of the embodiments of the invention, it is envisage that the polarization currents to which the elements of the system are subjected are equal to or greater than 10 mA.

The digital data to be acquired, according to one of the embodiments of the invention, correspond to a voltage signal of around 110V.

The possibility of incorporating the present invention into a control system for an air conditioning unit, such as the ones installed on the subway cars or other types of air-conditioned vehicles, is envisaged. Thus, according to one of the particular embodiments, the system of the present invention can comprise a control board for an air conditioning system.

According to one of the embodiments of the invention, the control module comprises a microprocessor.

A second aspect of the invention relates to a method for acquiring digital data in synchronized sequential circuits controlled by a synchronization signal with a period T (which can be fixed or variable). The method comprises the following steps:

a) receiving a first item of input data in the capturing module, in a first synchronization cycle;
b) transmitting the first item of input data to a memory module from the capturing module;
c) requesting from the memory module, in a second synchronization cycle, an input-data reading, by means of a microprocessor;
d) providing the first item of data to the microprocessor from the memory module;
e) receiving a second item of input data in the capturing module, in the second synchronization cycle;
f) transmitting the second item of data from the capturing module to the memory module;
g) replacing the first stored item of data by the second item of data, in the memory module.

Additionally, enabling the capturing module to receive input data with a period T according to the synchronization signal is envisaged.

When no input-data reading is necessary, according to one of the embodiments of the invention, disabling the capturing module is envisaged.

Optionally, before receiving a first and a second item of input data in the capturing module, previously transmitting an activation signal from the synchronization module to the capturing module is envisaged in one of the embodiments.

The present invention can be configured to cyclically repeat steps a) - g) according to the established period T, such that advantageously, one item of data is always in the memory module, available to be read by the microprocessor. Advantageously, the item of data can be instantly delivered without delay, since at the request of the microprocessor, the item of data delivered corresponds to the previous synchronization cycle.

Transmitting an item of data from the capturing module to the memory module, according to one of the embodiments of the present invention, can comprise polarizing an optocoupler inserted in the capturing module upon receiving an input signal and, subsequently, transmitting its state to a bistable multivibrator (latch) in the memory module. The time required for these operations is advantageously saved by requesting a reading by means of the microprocessor, delaying the phase of the readings delivered by one period.

Transmitting data to the memory module, according to one of the embodiments of the present invention, can further comprise previously receiving a memory signal in the memory module sent from the synchronization module.

Therefore, the present invention solves the existing problem in the state of the art of dissipative readings that imply continuous read systems, especially when the voltage to be measured is high and needs to be measured with sufficient current (typically between 10mA and 20mA). In light of this problem, the present invention proposes a procedure for reading measurements of non-continuous digital voltage with very little dissipation, yet, unlike other solutions that are non-continuous and isolated in the state of the art, the procedure proposed does not have long wait times, but instead immediately delivers the item of data after the request by the processor. This leads to a minimum power consumption that prevents the heating of the system that is so harmful to electronic components, such as control boards.

Furthermore, the present invention can be implemented in existing systems without the need to modify the control logic, and the optocouplers used do not need to be high-speed, since the delay thereof does not affect the data availability in the microprocessor.

## DESCRIPTION OF THE DRAWINGS

As a complement to the description provided herein, and for the purpose of helping to make the characteristics of the invention more readily understandable, a set of figures is attached as an integral part of said description, which, by way of illustration and not limitation represent the following:

Figure 1 shows a read circuit of a non-isolated digital voltage signal of continuous measurement, according to a solution in the state of the art.

Figure 2 shows a block diagram, according to one of the embodiments of the invention, showing the modules that comprise the digital data acquisition system with power reduction in detail.

Figure 3 shows a diagram wherein the times for digital data acquisition can be seen simultaneously.

Figure 4 shows a diagram of the capturing module wherein, according to a particular embodiment, a control circuit has been added, in charge of blocking the polarization of the optocoupler whenever it is not necessary to take a reading.

Figure 5 shows a diagram of the memory module, wherein according to a particular embodiment of the invention, the memory module has been modified, adding a control signal.

Figure 6 shows a diagram of the synchronization module of the system, according to a one of the embodiments of the invention.

## DETAILED DESCRIPTION OF THE INVENTION

That which is defined in this detailed description is provided to help achieve a comprehensive understanding of the invention. Thus, a person with average skill in the art will recognize that there are possible variations, changes and modifications to the embodiments described in the present specification without detracting from the scope of the invention. Moreover, a description of the functions and elements and the elements that are well known in the state of the art has been omitted for reasons of clarity and concision.

Of course, the embodiments of the invention can be implemented in a wide variety of architectural platforms, protocols, devices and systems, and therefore the specific designs and implementations presented in this document are provided solely for purposes of illustration and comprehension, and never to limit aspects of the invention.

The present invention discloses a method and a system for reading digital data that reduces power dissipation without modifying the input levels, and isolating these input circuits of the control devices for the protection thereof, wherein multiple readings of digital voltage/current signals of different types are taken, to be adapted and delivered to a control system of sequential reading by means of circuits able to isolate the different parts of the circuit and control each one of the readings as a function of the requests made by the control in a way that is independent from the required read time and without modifying the voltage and current levels required by the input. To this end, the system delivers the stored item of data in a time t-T to the processor, using the period T between requests from the processor for storing a new item of data.

According to one of the embodiments, a control module makes a request for an item of data of the measurement of the digital voltage signal periodically with period T. To read this item of data, a non-continuous measurement is taken of the input signal with synchronized isolation with regard to the requests for control, such that in each period T a measurement is taken that is stored in a log and which will be the measurement that is delivered to the control of the following request. Therefore, when the control requests an item of data in a time t, the item of data measured and stored in the previous request t-T is delivered and a new measurement is taken that is stored for the next request.

The present invention, according to one of the embodiments, has several modules for adapting and generating control signals. It is based on a microprocessing system of digital inputs of sequential reading, in which initially there is a signal adaptation system in charge of adapting the levels to a control system, which is in charge of reading said inputs sequentially. In the input of all systems there are input conditions that determine the necessary levels of voltage and current, as well as a period (T) for reading the signal implemented by the processor. Without varying these parameters, the present invention takes periodic readings of inputs, storing the value obtained in a buffer and delivering the stored value to the processor in the following request. To take these readings, the signal generated by the processor can be used, such that the stored value is renewed after each read request. Therefore, the present invention advantageously reduces the dissipated power without the need to modify the input or control conditions.

Figure **2** shows a block diagram, according to one of the embodiments of the invention, showing the modules that comprise the digital data acquisition system with power reduction in greater detail. In said figure the following modules are included:

- An input capturing module (21): configured to adapt the levels of the input signal and having a deactivation circuit and, according to a particular embodiment, with galvanically isolated circuits that protect the control systems from importune signals.
- A bistable multivibrator (22) that stores the readings taken at the input.
- A microprocessor (23) configured to execute the control of the system and take readings of data buses in a sequential way.
- A synchronization module (24) of the system that generates a signal (28) /LE that activates the input capturing module and memory of the reading in the bistable multivibrator.
- A circuit (25) for activating the input capturing module.

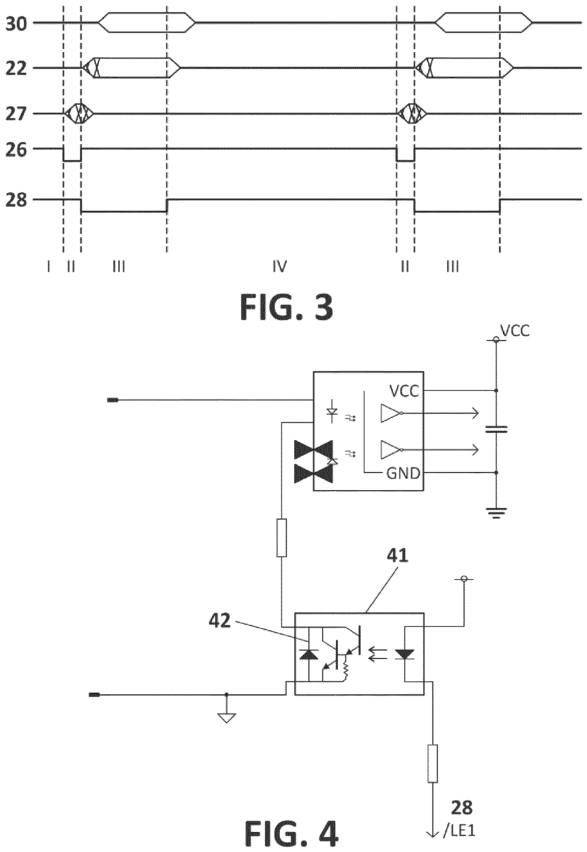

With regard to the operating sequence of the system, according to one of the embodiments of the invention, it begins with the start-up. In the start-up of the system, there still has not been a reading, the capturing module is blocked and the data stored in the bistable multivibrator is unknown. The microprocessor then begins to read the data, activating a signal /OE (26) and receiving the item of data (27) stored in the bistable multivibrator. Once the reading is completed, the synchronization module of the system generates the signal /LE (28) that is in charge activating the input capturing module and storing the reading obtained in the bistable multivibrator. This way, the valid item of data is stored in the bistable multivibrator, waiting for a new reading by the microprocessor. The microprocessor will take another reading, cyclically repeating the same aforementioned sequence, which is represented in **figure 3**, wherein the times of digital data acquisition can be seen on different lines for the input in the capturing module (30), bistable multivibrator (22), data stored in the bistable multivibrator (27), signal /OE (26) and signal /LE (28). It is worth mentioning the reduction in power consumption which, as seen in **figure 3** is reduced to the third period without modifying the operating conditions, such that it can be incorporated into previously developed systems without the need to modify the basic parameters of the system, in other words, maintaining the voltage of the input signals and preventing significant modifications of the system. Particularly, the processor does not need any modification, since the present invention stores the data read and delivers them to the processor in the following read cycle. The polarization currents of the input are also maintained, thereby preventing undesirable effects, such as false positives due to small derivations or fretting, sometimes accompanied by corrosive damage, which occasionally appears on surfaces with a certain roughness and is caused by relative oscillatory movements with a very small amplitude, such as a vibration, between the pieces that are in contact through a charge.

One of the embodiments of the present invention relates to the application of the previously described method and system for control boards for air-conditioning systems, for example in those systems that are mounted in transportation vehicles with passengers, such as subway cars. The characteristics for the design of these vehicles require that the control boards work with auxiliary voltage around 1110V for the digital inputs thereof, common to all devices (however, considerable variations are tolerable and can admit large voltage fluctuations). Moreover, due to the characteristics of the devices that command the polarization of these inputs, the polarization current must not be less than 10 mA so as to prevent fretting, as well as small derivations.

These types of systems test each one of the inputs by means of a circuit for adapting current, which polarizes the diode of an optocoupler device and, at the output thereof, the signal is transparently stored in a memory element, for example a bistable multivibrator (latch), commanded at the output thereof by the processor.

In the digital inputs of these types of boards, optocoupler is polarized from the input signal, transmitting the state to the isolated part that is immediately stored in a multivibrator and this way the processor, by means of a read request signal of the processor (we will refer to the it as "/OE") which the same controls, can obtain the states of each one of the inputs in the data bus.

The drawback of this model is the power that must be dissipated in each one of the active inputs, around 1.1W, according to the following function:

$$P_I = \frac{1}{T} \int_0^T V_I * I_I \, \partial t = V_I * I_I = 110V * 10mA * 1 = 1{,}1W \qquad (1)$$

such that, as shown in (1) for a period T of the active channel, the voltage and intensity applied are constant, and therefore the power dissipated will be 1.1W, if the total amount of inputs is taken into account, for example 24 equal inputs, and the maximum power dissipated would reach 26.4 W. This dissipation generates a large amount of heat that leads to poor operation, reducing the life of the board, and moreover is an unjustified waste of power.

The present invention easily solves this specific case, taking into consideration that boards of this type contain the adaptation circuit in an easily insertable supplementary board, and therefore, all that needs to be done is to substitute this adaptation circuit according to the present invention and follow all of the parameters indicated by the system as described below.

**Figure 4** shows a diagram of the capturing module (21) wherein, according to a particular embodiment, a control circuit (41) has been added, in charge of blocking the polarization of the optocoupler whenever it is not necessary to take a reading. To this end, an optocoupling system is inserted in the reverse direction (42), able to support the voltage and current values of the system. This way, the circuit 41 is in charge of activating the input whenever it is necessary to take a reading by means of the signal /LE (28), which is generated in the synchronization module that is explained in detail further on.

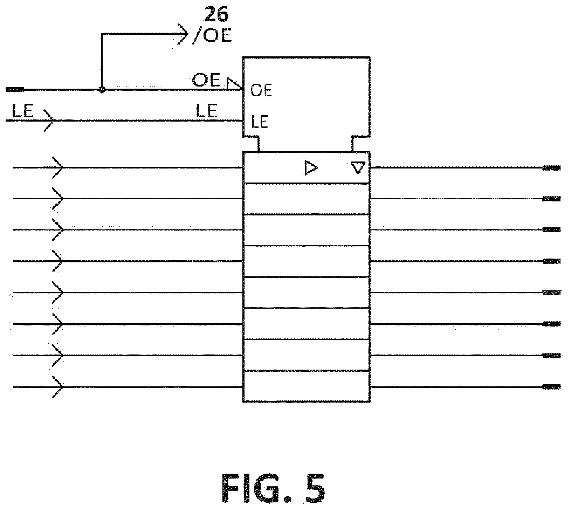

**Figure 5** shows a diagram of a memory module (22) wherein, according to a specific embodiment of the invention, consists of a latch or bistable multivibrator. Given that the read time of the inputs is limited by the synchronization module, this reading must be synchronized with the memory of the data within the multivibrator, and therefore the memory module is modified, adding an enabling signal of the internal multivibrator, which we will call LE, able to guarantee that at the moment of reading the item of data that we have at the input of the multivibrator, it is a valid item of data and wherein, furthermore, the signal /OE generated by the processor is used in the synchronization module to generate the rest of the necessary control signals.

With regard to the microprocessor (23), it actually remains invariable, which represents one of the advantages of the present invention, achieving a power reduction without the need to modify the external parameters or control systems for both the hardware and software. This way, when a reading is required of the inputs of the system, all that needs to be done is for the enabling signal to be activated and the data delivered in the data bus for the interpretation thereof, with the only exception in that the item of data obtained will be read in a time t-T with a period corresponding to that which is used by the processor. Therefore, the requirement for proper operation is that the microprocessor takes readings of the inputs in a sequential way and that the reading period is greater than that which is required by the synchronization module to write the item of data on the memory module.

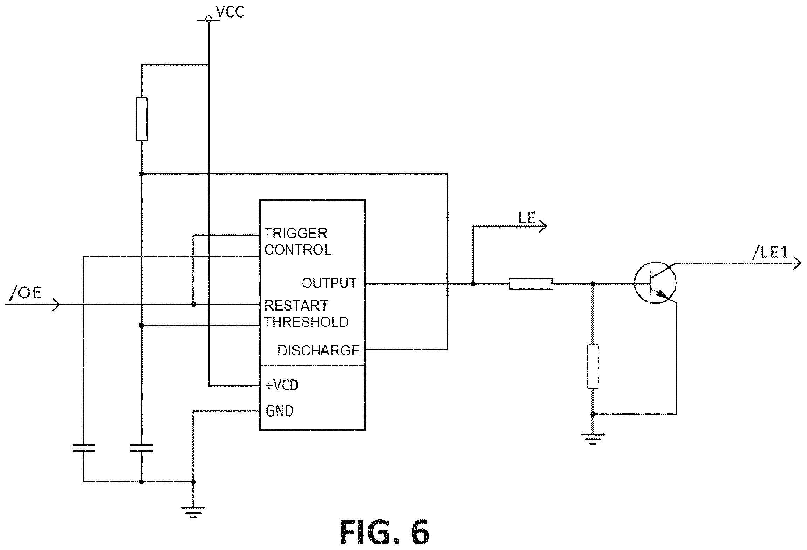

**Figure 6** represents the synchronization module (24) of the system, which is in charge of generating the necessary signals in order to activate the input capturing module and store the item of data obtained in the memory module. To this end, in this particular embodiment, a monostable circuit active to the extinction of the signal /OE has been implemented such that it guarantees the veracity of the data obtained. The signal generated LE for the memory of the item of data in the memory module will be active until it is guaranteed that a valid item of data is provided from the input by the activation of the signal/LE1.

Lastly, to highlight the advantages obtained by the present invention, we can focus on the reduction of dissipated power that is obtained in this specific example, developed according to the present invention, and compare it to the initial figures. Thus, as was previously mentioned and according to the function (1), the power dissipated by each one of the active inputs during a period T is 1.1 W. Considering that in this particular case a reading of the input is taken every 50ms, the time that the capturing module must be active to store the item of data is approximately 200$\mu$s, and thus we obtain a dissipated power of:

$$P_I = \frac{1}{T_{OE}} \int_0^{t_{LE}} V_I * I_l \partial t = V_I * I_l * \frac{t_{LE}}{T_{OE}} = 110V * 10mA * \frac{200 * 10^{-6}}{50 * 10^{-3}} = 4,4mW \tag{2}$$

Where,

$t_{LE}$, is the activation period of the capturing module

$T_{OE}$, is the period between two readings of the processor

It is clear that the system implemented according to the present invention manages infimum power values (compared with the initial values) without the need to modify the working conditions of the input devices and without modifying the control circuits both in relation to the hardware and software arrangement thereof.

EP 3 349 133 A1

**Claims**

1. A system for acquiring digital data in synchronous sequential circuits controlled by a signal with period T, **characterized by** comprising the following elements:

   - a capturing module that reads input data with a period T;
   - a memory module that stores the input data read by the capturing module;
   - a controller module that requests input data readings from the memory module and receives the input data stored by the memory module corresponding to the period before the request of the reading;

2. The system according to claim 1, wherein the capturing module further comprises an activation circuit that disables the capturing module when it is not necessary to acquire input data.

3. The system according to claim 2, wherein the activation circuit comprises an optocoupled system in the reverse direction.

4. The system according to any of the preceding claims, wherein the memory module is a latch.

5. The system according to any of the preceding claims, which further comprises a synchronization module that generates the synchronization signal that controls the circuit and further generates an activation signal for the capturing module and a memory signal for the memory module.

6. The system according to any of the preceding claims, wherein the capturing module comprises a galvanically isolated circuit.

7. The system according to any of the preceding claims, wherein the elements comprise polarization currents equal to or greater than 10 mA.

8. The system according to any of the preceding claims, which further comprises a control board of an air-conditioning system.

9. A method for acquiring digital data in synchronous sequential circuits controlled by a synchronization signal with period T, **characterized in that** it comprises the steps of:

   a) receiving a first input data in the capturing module, in a first synchronization cycle;
   b) transmitting the first item of input data from the capturing module to a memory module;
   c) requesting from the memory module, in a second synchronization cycle, an input-data reading, by means of a controller module;
   d) providing the first item of data to the controller module from the memory module;
   e) receiving a second input data in the capturing module, in the second synchronization cycle;
   f) transmitting the second item of input data from the capturing module to the memory module;
   g) replacing the first stored item of data by the second item of data in the memory module.

10. The method according to claim 9, which further comprises enabling the capturing module to receive input data with a period T according to the synchronization signal.

11. The method according to any of the preceding claims 9-10, which further comprises enabling the capturing module when no reading is necessary.

12. The method according to any of the preceding claims 9-11, wherein the steps a) - g) are cyclically repeated according to a period T, such that in the memory module there is always an item of data available to be read by the controller module.

13. The method according to any of the preceding claims 9-12, wherein transmitting an item of data from the capturing module to the memory module comprises polarizing an optocoupler inserted in the capturing module when receiving an input signal and, subsequently, transmitting its state to a latch in the memory module.

14. The method according to any of the preceding claims 9-13, wherein receiving a first and a second item of input data in the capturing module further comprises previously transmitting an activation signal from the synchronization module to the capturing module.

15. The method according to any of the preceding claims 9-14, wherein transmitting data to the memory module further comprises previously receiving a memory signal in the memory module sent from the synchronization module.

**FIG. 1**

**FIG. 2**

# FIG. 3

# FIG. 4

**26**
/OE

OE

OE

LE

LE

LE

▷ ▽

# FIG. 5

**FIG. 6**

VCC

TRIGGER
CONTROL

OUTPUT

/OE

RESTART
THRESHOLD

DISCHARGE

+VCD

GND

LE

/LE1

# INTERNATIONAL SEARCH REPORT

| International application No. |
| --- |
| PCT/ES2016/070638 |

## A. CLASSIFICATION OF SUBJECT MATTER

*G06F17/40* (2006.01)

According to International Patent Classification (IPC) or to both national classification and IPC

## B. FIELDS SEARCHED

Minimum documentation searched (classification system followed by classification symbols)
G06F

Documentation searched other than minimum documentation to the extent that such documents are included in the fields searched

Electronic data base consulted during the international search (name of data base and, where practicable, search terms used)

EPODOC, INVENES, WPI, NPL, XPESP, XPAIP, XPI3E, INSPEC.

## C. DOCUMENTS CONSIDERED TO BE RELEVANT

| Category* | Citation of document, with indication, where appropriate, of the relevant passages | Relevant to claim No. |
| --- | --- | --- |
| X | US 6427129 B1 (LALLA ROBERT) 30/07/2002, of column 1, line 62 a column 6, line 24; figures 1-2. | 1 |
| Y | | 2-15 |
| X | US 2013268736 A1 (OKAMOTO MASAYUKI   ET AL.) 10/10/2013, paragraph [0011]  a [0049]; figures 1-6. | 1 |
| Y | | 2-15 |

☐ Further documents are listed in the continuation of Box C.          ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means. | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | "&" document member of the same patent family |

| Date of the actual completion of the international search | Date of mailing of the international search report |
| --- | --- |
| 15/11/2016 | **(16/11/2016)** |
| Name and mailing address of the ISA/ <br><br> OFICINA ESPAÑOLA DE PATENTES Y MARCAS <br> Paseo de la Castellana, 75 - 28071 Madrid (España) <br> Facsimile No.: 91 349 53 04 | Authorized officer <br> J. Botella Maldonado <br><br><br> Telephone No. 91 3495382 |

Form PCT/ISA/210 (second sheet) (January 2015)

## INTERNATIONAL SEARCH REPORT

Information on patent family members

| | | International application No. |
|---|---|---|
| | | PCT/ES2016/070638 |

| Patent document cited in the search report | Publication date | Patent family member(s) | Publication date |
|---|---|---|---|
| US6427129 B1 | 30.07.2002 | JPH1186176 A | 30.03.1999 |
| | | JP2911888B B2 | 23.06.1999 |
| | | EP0892249 A1 | 20.01.1999 |
| | | EP0892249 B1 | 14.08.2002 |
| | | DE19730158 A1 | 18.02.1999 |
| US2013268736 A1 | 10.10.2013 | JP2013218464 A | 24.10.2013 |
| | | JP5701810B B2 | 15.04.2015 |
| | | CN103364016 A | 23.10.2013 |

Form PCT/ISA/210 (patent family annex) (January 2015)